# EUROPÄISCHE PATENTSCHRIFT

(11) **EP 0 505 391 B1**
(45) Veröffentlichungstag und Bekanntmachung des Hinweises auf die Patenterteilung: **14.09.1994**
(21) Anmeldenummer: 91900119.8
(22) Anmeldetag: 10.12.1990
(51) Int. Cl.: G01R 29/10, G01R 35/00, H01Q 21/29, H03B 19/14

(54) **KAMMGENERATOR SOWIE KALIBRIERUNGEINRICHTUNG UND VERFAHREN ZUR KALIBRIERUNG VON MESSSTRECKEN FUER STOERFELDSTAERKEMESSUNGEN**
COMB GENERATOR, DEVICE AND PROCESS FOR THE CALIBRATION OF RADIATED-EMISSION TEST SITES
GENERATEUR DE PEIGNE, DISPOSITIF ET PROCEDE D'ETALONNAGE DE SECTIONS DE MESURE SERVANT A LA DETERMINATION DES INTENSITES DES CHAMPS PARASITAIRES

(30) Priorität: 11.12.1989 AT 2796/89
(43) Veröffentlichungstag der Anmeldung: 30.09.1992
(73) Patentinhaber: Österreichisches Forschungszentrum Seibersdorf Ges.m.b.H., 1010 Wien (AT)
(72) Erfinder: GARN, Heinrich, A-1210 Wien (AT); RASINGER, Josef, A-2340 Mödling (AT); Müllner Wolfgang, A- 2486 Landegg (AT)
(86) Internationale Anmeldenummer: AT9000119
(87) Internationale Veröffentlichungsnummer: WO9109317

(56) Entgegenhaltungen:
- DE-A- 2 602 476
- DE-A- 3 322 325
- GB-A- 2 123 256
- US-A- 4 864 636

## Beschreibung

Die Erfindung betrifft einen Meßsender gemäß dem jeweiligen Oberbegriff der Patentansprüche 1 und 3. Die Erfindung betrifft ferner ein Verfahren zum kalibrieren von Meßstrecken gemäß dem Oberbegriff des Patentanspruches 16.

Verfahren zum Kalibrieren von Meßstrecken für Störfeldstärkemessungen von elektrischen Geräten sind insofern bekannt, als in einer bekannten Referenzmeßstrecke von einer einzigen abstrahlenden Antenne die Meßdaten gewonnen werden und an demselben Funkstörsender entsprechende Messungen in der zu kalibrierenden Meßstrecke vorgenommen werden und aus einem Vergleich der beiden Messungen die entsprechenden Kalibrierfaktoren ermittelt werden. Ein derartiges Verfahren ist beispielsweise aus e&i-Elektrotechnik & Informationstechnik, Band. 106 (1989), Nummer. 4, Seite 134 - 145 (wovon ausgehend der jeweilige Oberbegriff der vorliegenden Ansprüche 1,3 und 16 gebildet ist) bekannt. IEEE 1989 National Symposium on Electromagnetic Compatibility, 23.-25. Mai, Seite 391, Spalte 1 offenbart ebenfalls ein Verfahren zum Kalibrieren von Meßstrecken. Ein ähnliches Verfahren ist aus 1986, IEEE International Symposium on Electromagnetic Compatibility, 16. - 18. Sept. 1986, Seiten 362 - 365 bekannt. Dieses Verfahren sieht aber lediglich eine Doppelantenne vor und kalibriert die Meßstrecke ausschließlich für diese eine Doppelantenne.

Aus der DE-A-2 602 476 ist ein Peilantennensystem unter Verwendung eines Dipols und einer unter Zuhilfenahme eines Kopplungsgliedes angeschlossenen Rahmenantenne bekannt, das jedoch nicht für Kalibrierzwecke einsetzbar ist.

Aus Patent Abstracts of Japan, Band 9, Nummer 210 (P-383) 1938 28. August 1985 ist die Ansteuerung zumindest zweier, unterschiedliche Abstrahlcharakteristiken aufweisender Antennen bekannt, um das Ansprechverhalten einer Radaranlage zu verbessern; eine derartige Radaranlage ist jedoch für Kalibriermessungen der erwähnten Art nicht einsetzbar.

Aus Q.S.T. amateur radio, Band 56, Nummer 5, Mai 1972, Seiten 16,17 ist die Verwendung eines im kontrollierten Lawinendurchbruch betriebenen Bipolartransistors, dessen beim Durchbruch gewonnenes, frequenzstabiles Signal bis 1 GHz reicht, zur Erstellung eines Impulsgenerators bekannt. Der Einsatz derartiger Transistoren für Kammgeneratoren bzw. der Einsatz derartiger Impulsgeneratoren für die Antennenanspeisung für Kalibrierzwecke ist jedoch dieser Schrift nicht zu entnehmen.

Elektrische und elektronische Geräte erzeugen elektromagnetische Felder. Dies folgt aus der physikalischen Tatsache, daß jeder zeitlich veränderliche elektrische Strom die Abstrahlung elektromagnetischer Wellen zur Folge hat.

Im Falle eines Funksenders werden diese Wellen mit Absicht erzeugt und sind erwünscht (Radiowellen). In elektrischen bzw. elektronischen Geräten werden ebenfalls zeitlich veränderliche elektrische Ströme verwendet bzw. verursacht, z.B. in Rechnern, Haushaltsgeräten od.dgl. Diese Ströme werden zwar mit Absicht erzeugt, die mit den Strömen verbundene Wellenabstrahlung bzw. Felderzeugung ist jedoch unerwünscht, weil dadurch andere elektrische bzw. elektronische Systeme in ihrer Funktion gestört werden können. Solche unerwünschte Beeinflussungen müssen vor allem dort verhindert werden, wo sicherheitstechnisch relevante elektronische Systeme gestört werden können, z.B. die Steuerungselektronik in Flugzeugen oder Kraftfahrzeugen, medizintechnische Einrichtungen usw. Unerwünschte Wellenabstrahlung von elektronischen Geräten muß daher durch technische Maßnahmen, z.B. Gehäuseabschirmungen, Filterung von Leitungen usw., auf weniger als das höchstzulässige Maß reduziert werden.

"Elektromagnetisch verträglich" zu sein, ist ein wichtiges Qualitätsmerkmal von Produkten der Elektro- und Elektronikindustrie. Um diese Qualitätseigenschaft in einem Produkt zu prüfen, müssen sowohl das aktive Störvermögen (Emission elektromagnetischer Felder) als auch die Störfestigkeit (gegen Immission solcher Felder) gemessen werden.

Für den Bereich der Emission werden von den Zulassungsbehörden (z.B. Österreichische Post- und Telegraphenverwaltung) Grenzwerte der zulässigen Störstrahlung bzw. Störfeldstärke festgesetzt. Die Meßverfahren zur Bestimmung der von einem Prüfling erzeugten Störfeldstärke sind genormt. Die Messungen können entweder im Freien, d.h. auf einem sogenannten "Freifeld-Meßgelände" oder in elektromagnetisch abgeschirmten, mit Hochfrequenzabsorbern ausgekleideten Hallen (Absorberhallen) durchgeführt werden. Letztere bieten den Vorteil der Störungsfreiheit gegenüber Fremdfeldern (Rundfunksender) sowie der Witterungsunabhängigkeit. Die Hochfrequenzabsorber sind erforderlich, um Reflexionen der vom Prüfling ausgestrahlten elektromagnetischen Wellen von den Wänden zu verringern.

Die Wellenausbreitungsbedingungen auf einem für Störfeldstärkemessungen eingesetzten Meßgelände haben maßgeblichen Einfluß auf das Meßergebnis. An ein und demselben Prüfling kann man völlig unterschiedliche Meßwerte der Störstrahlung erhalten, wenn man zwei hinsichtlich ihrer Wellenausbreitungsbedingungen unterschiedliche Betriebsorte wählt. In Absorberhallen können insbesondere unerwünschte Reflexionen von den Absorberwänden die Meßergebnisse unzulässig verfälschen. Einzige Abhilfemaßnahme ist die Kalibrierung der Meßstrecke.

Für die Kalibrierung eines Freifeldmeßgeländes wurde eine Meßprozedur genormt (DIN-VDE 0877 Teil 2).Eine präzise Festlegung für Absorberhallen existiert nicht; die für das Freifeld genormte Methode ist für Absorberhallen völlig unzureichend, da völlig unterschiedliche Umgebungsgegebenheiten vorliegen. Bei dieser Kalibrierungsart von Meßstrecken nach dem Konzept der Felddämpfung wird die Übertragungsdämpfung zwischen zwei gleich polarisierten Halbwellendipolen, die auf dem Freifeldmeßgelände aufgestellt sind, als Felddämpfung bezeichnet, wenn genormte räumliche Anordnungen und Meßverfahren eingehalten werden, wie sie z.B. in VDE 0877 Teil 2 (1985) beschrieben sind. Eine im realen Gelände gemessene Felddämpfung ist mit den entsprechenden theoretisch berechneten Werten eines idealen Geländes zu vergleichen, wobei Abweichungen bei Störfeldstärkemessungen an Prüflingen auf diesem Gelände als Korrekturwerte berücksichtigt werden. Es erfolgt somit eine Berechnung der Kalibrierfaktoren aufgrund eines Vergleiches von Freifeldmeßgeländemeßwerten mit theoretischen Werten.

Bei dieser Methode wird angenommen, daß nicht ideale Meßplatzeigenschaften auf Felddämpfungsmessungen die gleichen Auswirkungen haben wie auf Feldstärkemessungen an Prüflingen. Dies ist jedoch insbesondere nicht der Fall, da reale Prüflinge völlig andere geometrische Abmessungen haben können als resonante Halbwellendipole und ferner von den Prüflingen völlig andere Feldverteilung erzeugt werden können als von den zur Kalibrierung herangezogenen Dipolantennen.

Durch Felddämpfungsmessung ermittelte Korrekturterme treffen daher streng genommen auf reale Prüflinge sicherlich nicht zu; diese Tatsache kann insbesondere bei Störfeldstärkemessungen in Absorberhallen, die nach dem Konzept der Felddämpfung kalibriert wurden, zu unzulässig hohen Meßfehlern führen.

Ferner sind Funkstörsender mit dipolartigen Sendeantennen bekannt, die batteriebetriebene Kammgeneratoren umfassen, die fix mit einer linearen (dipolartigen) Sendeantenne verbunden sind. Derartige Vorrichtungen können für Vergleichsmessungen zwischen verschiedenen Meßstrecken herangezogen werden; dabei wird wiederum nur eine ganz spezielle Feldverteilung erzeugt und alle Ergebnisse derartiger Vergleichsmessungen gelten wiederum nur für diese eine Feldverteilung. Eine Verallgemeinerung der gewonnenen Meßergebnisse auf beliebige reale Prüflinge ist bei auf diese Art vermessenen Absorberhallen nicht möglich.

Ferner sind auch Funkstörsender mit sphärischer Dipolantenne bekannt, die batteriebetriebene Kammgeneratoren umfassen, die in zwei metallischen,elektrisch voneinander isolierten Kugelhalbschalen eingebaut sind, die einen sphärischen Dipol darstellen. Solche Vorrichtungen können wie die zuvor beschriebenen Funkstörsender eingesetzt werden, jedoch wird wiederum nur eine spezielle Feldverteilung vermessen und die gewonnenen Meßergebnisse haben daher keine allgemeine Gültigkeit.

Alle drei bekannten Arten von Kalibriereinrichtungen haben demzufolge den Nachteil, daß sie nur jeweils einen einzigen Typ von Feldverteilung generieren können; reale elektronische Geräte erzeugen üblicherweise jedoch eine Vielzahl stark unterschiedlicher Feldbilder. Um in den heute in der EMV-Meßtechnik (elektromagnetische Verträglichkeit) vorwiegend eingesetzten Absorberhallen Störfeldstärkemessungen bei Frequenzen unterhalb von ca. 150 MHz durchführen zu können, muß die Meßstrecke in der Halle für alle in der Praxis auftretenden Feldverteilungen kalibriert werden. Wird, wie bisher von der Fachwelt als ausreichend angesehen wurde, nur für eine einzige Feldverteilung kalibriert und- werden diese Kalibrierfaktoren bei allen Prüfungen von elektronischen Geräten verwendet, so kann die Meßunsicherheit weit über das zulässige Maß hinaus ansteigen.

Aus der DE-A- 3 322 325 ist ein reiner Störsender bekannt, der einen herkömmlichen Kammspektrumgenerator umfaßt, dessen Impulse gefiltert und verstärkt werden und daraufhin in die Antenne gespeist werden. Damit sollen mit großer Sendeleistung in beträchtlicher Entfernung Störfelder erzeugt werden. Zur Kalibrierung von Meßfeldstrecken ist dieser bekannte Störsender ungeeignet, weil sein Frequenzband beschränkt ist und die Sendeleistung nicht für Nahfeldmessungen ausgelegt ist.

Ziel der Erfindung ist die Erstellung eines Meßsenders sowie eines Verfahrens der eingangs genannten Art, mit denen die Nachteile der bekannten Vorrichtungen und Vorgangsweisen vermieden werden können und praxisgerechte Kalibrierfaktoren ermittelt bzw. Normstandard besitzende Meßstrecken erstellt und betrieben werden können.

Der eingangs genannte Meßsender ist erfindungsgemäß gekennzeichnet durch die Merkmale des Patentanspruches 1 bzw.3. Das eingangs angeführte Verfahren ist erfindungsgemäß gekennzeichnet durch die Merkmale des Patentanspruches 16. Mit diesem Meßsender bzw. diesem Verfahren ist es möglich, für zu kalibrierende Meßstrecken Kalibrierfaktoren zu ermitteln, sodaß Messungen, die in diesen Meßstrecken durchgeführt werden, ins Verhältnis zu Freifeld-Meßgelände-Messungen gesetzt werden können und damit Prüflinge vermessen werden können, welche Messungen genauestens auf die vorgegebene Norm bezogen werden können.

Der erfindungsgemäße Meßsender ist ein einfaches und betriebssicheres Gerät, das für die Ausstrahlung von verschiedenen Wellen eingerichtet ist, die entsprechend unterschiedliche Feldverteilungen in den Meßstrecken bewirken, wobei für die einzelnen Feldverteilungen jeweils Kalibrierfaktoren ermittelt werden, sodaß Prüflinge nicht nur bezüglich einer charakteristischen Feldverteilung vermessen werden können, sondern Meßwerte für die verschiedensten abgestrahlten Feldformationen ausgewertet werden können und das gesamte Störspektrum der Prüflinge erfaßt werden kann.

Der einen Kammgenerator umfassende Meßsender bietet neben seiner Amplituden- und Frequenzstabilität auch den Vorteil einer hohen Leistung bei gleichzeitig einfachem Aufbau und ermöglicht, daß die von nahezu allen elektrischen Geräten ausgehenden Funkstörungen optimal simuliert werden können. Insbesondere kann man den unmittelbaren Nahbereich des störenden Gerätes bis zu ca. 30 m Abstand simulieren bzw. die entsprechenden Kalibriergrößen berechnen. Die Sendeleistung des erfindungsgemäßen Meßsenders kann relativ gering bemessen werden und trotzdem erhält man ein ausreichend breites amplituden- und frequenzstabiles Kammspektrum. Es wird eine möglichst hohe Anzahl von Meßfrequenzen zur Verfügung gestellt, ohne das Spektrum durch Filter einzuengen; eine Leistungsverstärkung des Antennensignals ist nicht erforderlich, da durch den im Lawinendurchbruch betriebenen Transistor ausreichende Leistung zur Verfügung gestellt wird. Damit werden ferner eine geringe Baugröße, ein geringer Stromverbrauch und damit die Möglichkeit des Batteriebetriebs über längere Zeit ermöglicht. Dies ist insbesonders auch von Bedeutung, da bei den üblichen Störsendern die Sendeantennen im Hinblick auf die bestmögliche Abstrahlungswirkung optimiert werden, wogegen bei den erfindungsgemäßen Meßsendern die Antennen derart ausgewählt werden, daß mit ihnen Abstrahlungen von elektrischen Geräten bestmöglich simuliert werden können.

Durch Verwendung eines im kontrollierten Lawinendurchbruch betriebenen Transistors wird ferner eine sehr kurze Impulsdauer und damit ein Kammspektrum bis über 1 GHz erreicht, ohne daß aufwendige Verstärker eingesetzt werden müssen.

Neuartig und das Erfindungsprinzip ist es, daß die Kalibrierung der Meßstrecken erfolgt, indem nicht nur wie bisher die von einer einzigen Antenne bewirkte Feldverteilung vermessen wird, sondern die von zumindest zwei unterschiedlichen Antennen bewirkten Feldverteilungen zur Bestimmung der Kalibrierfaktoren herangezogen werden.

So wird bei dem Verfahren gemäß Patentanspruch 16 gefordert, mit zwei aufgrund ihres Konstruktionsprinzips unterschiedliche Abstrahlungscharakteristik besitzenden Antennen die Kalibrierfaktoren zu ermitteln, deren vorteilhafte Art und deren Aufbau in Patentanspruch 2 angegeben ist. Mit derartig aufgebauten Antennen können die meisten im wesentlichen auftretenden Feldverteilungen erzeugt bzw. nachgebildet und somit eine Reihe der wesentlichen Kalibrierfaktoren ermittelt werden. Spezielle Aussagen über die Kalibrierfaktorermittlung sind in den Patentansprüchen 17 und 18 enthalten.

Mit dem erfindungsgemäßen Verfahren ist es möglich, für zu vermessende Meßstrecken Kalibrierfaktoren zu ermitteln, sodaß Messungen, die in diesen Meßstrecken durchgeführt werden, ins Verhältnis zu Freifeld-Meßgelände-Messungen gesetzt werden können und damit Prüflinge vermessen werden können, welche Messungen auf die vorgegebene Norm bezogen werden können.

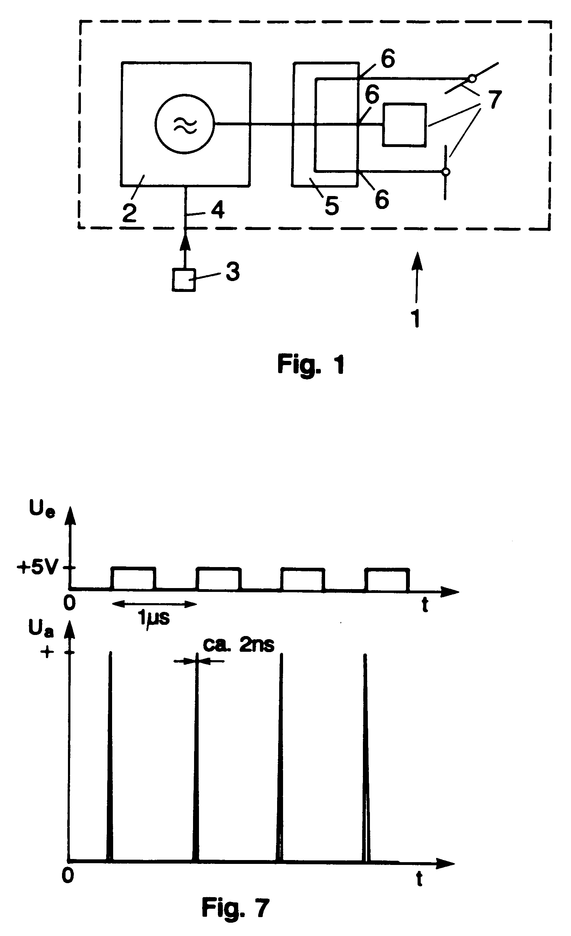

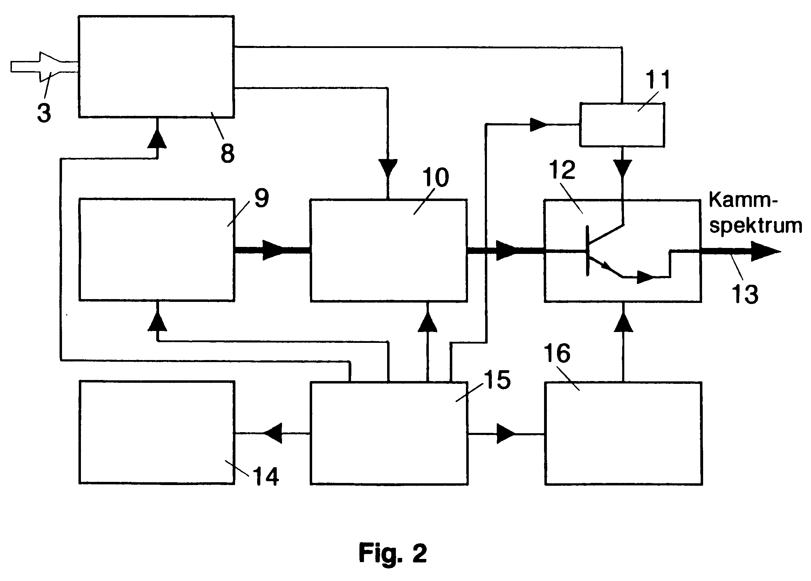

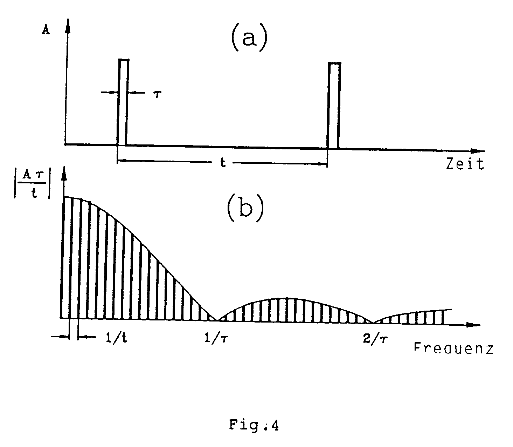

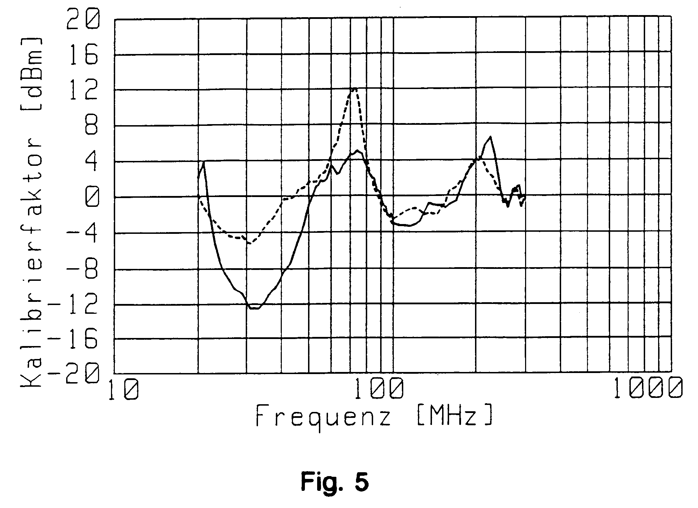

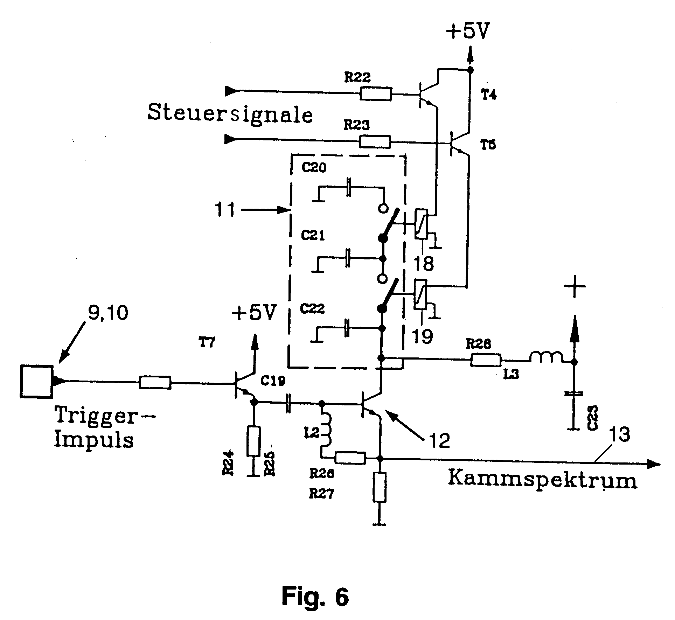

Im folgenden wird die Erfindung anhand der Zeichnung beispielweise näher erläutert. Es zeigt Fig.1 das Prinzip bzw. ein Blockschaltbild eines Meßsenders. Fig.2 zeigt das Blockschaltbild eines Kammgenerators, Bild 3a-3c zeigt verschiedene Kammspektren eines Kammgenerators, Fig.4a und 4b die zeitliche und spektrale Darstellung eines periodischen Impulses, Fig.5 Kalibrierfaktoren einer Absorberhalle, Fig. 6 ein Detail des Blockschaltbildes gemäß Fig.1 und Fig.7 ein Diagramm.

In Fig.5 sind die ermittelten Kalibrierfaktoren einer speziellen Absorberhalle als Funktion der Frequenz aufgetragen. Mit durchgehenden Linien sind die Kalibrierfaktoren bei einem gegebenen Meßabstand für lineare Antennen, mit strichlierten Linien für Rahmenantennen eingezeichnet. Zu bemerken ist, daß sich die Kalibrierfaktoren in Abhängigkeit von der Frequenz ändern, sodaß die Kalibrierfaktoren immer über einen Frequenzbereich zu bestimmen sind. Der Unterschied zwischen den Kalibrierfaktoren für Leitungen (lineare Strahler) und den für Leiterschleifen (Rahmenantennen) beträgt bis zu 8 dB, was einem Faktor von 6,4 entspricht. Beide Strahlerformen können in realen elektronischen Geräten enthalten sein, weshalb es notwendig ist, Meßstrecken auch für diese beiden Fälle zu kalibrieren. Zweckmäßigerweise ist somit vorgesehen, daß Meßhallen zumindest für die Abstrahlung von Leiterschleifen und für die Abstrahlung von Leitern kalibriert werden, wobei es vorteilhafterweise vorgesehen sein kann, daß noch weitere Kalibrierfaktoren ermittelt werden für andere Antennen mit charakteristischer Abstrahlung. Die Ermittlung der Abstrahlung von Rahmenantennen bzw. von linearen Strahlern ist jedoch die Mindesterfordernis zur zweckentsprechenden Vermessung von Absorberhallen.

Um beim Kalibriervorgang nicht beherrschbare Feldverzerrungen durch Antennenspeiseleitungen zu verhindern, soll das Referenzfeld von einem Generator erzeugt werden, der keinerlei metallische Zuleitungen hat. Andernfalls wäre es nicht ohne weiteres gewährleistet, daß bei Referenzmessung und Messung in der zu kalibrierenden Absorberhalle tatsächlich das gleiche Feld erzeugt würde, da bereits eine geringfügig unterschiedliche Lage einer metallischen Leitung das Meßergebnis beträchtlich verfälschen könnte. Bei der Kalibrierung einzusetzende Generatoren besitzen demzufolge keine metallischen Zuleitungen und sind batteriebetrieben und können gegebenenfalls von Lichtwellenleitern ferngesteuert arbeiten.

Ferner ist es vorteilhaft, wenn die Kalibriervorrichtung ein Generatorsignal erzeugt, daß es bei Referenzmessungen im Freien nicht durch Rundfunksender überdeckt wird. Dieses Generatorsignal muß ferner frequenz- und amplitudenstabil sein, um die automatische Durchführung der Messungen zu ermöglichen. Die Frequenzauflösung bei der Kalibrierung muß ferner so hoch sein, daß alle zu kalibrierenden Einflüsse auf die Wellenausbreitungsbedingungen genau erfaßt werden. Diese Bedingungen können bei einem erfindungsgemäßen Meßsender verwirklicht werden.

Gemäß Fig.1 besitzt ein derartiger Meßsender (Funkstörsimulator) 1 einen Kammgenerator 2 mit Stromversorgung insbesondere in batterieform und einer Steuerlogik 3, die über Lichtwellenleiter 4 mit dem Kammgenerator 2 verbunden ist. Das vom Kammgenerator 2 erzeugte Kammspektrum wird an Kopplungsglieder bzw ein Netzwerk 5 bzw. entsprechende Anschlußeinrichtungen zum Ankoppeln von Antennen 7 unterschiedlicher Abstrahlungscharakteristik weitergeleitet, sodaß diese Antennen 7 unterschiedlicher Abstrahlungscharakteristik entweder gleichzeitig oder einzeln hintereinander betrieben werden können. Möglich ist es hiebei z.B., Anschlüsse 6 für eine Mehrzahl von Antennen unterschiedlicher Abstrahlungscharakteristik vorzusehen oder auch nur einen einzelnen Anschluß 6, der entsprechend der angeschlossenen Antenne ein entsprechendes Kopplungsnetzwerk zugeordnet erhält, sodaß mit verschiedenen Antennen 7 hintereinander gesendet werden kann. Die einzelnen Antennen, die unterschiedliche Abstrahlungscharakteristik besitzen, sind mit 7 bezeichnet.

Fig.2 zeigt ein Blockschaltbild eines bei einen erfindungsgemäßen Meßsendereinsetzbaren Kammgenerators 2. Ein Quarzoszillator 9 steuert über eine Teilerschaltung 10 eine. Avalanchestufe bzw. einen im Lawinendurchbruch betriebenen (Bipolar) Transistor 12, der über eine Antennenanspeiseleitung 13 die Antennen 7 bzw. das (Kopplungs) Netzwerk 5 versorgt. Die Oszillatorschaltung 9, die Teilerschaltung 10 und ein Opto-Decoder 8 sind von einer Batterie 15 mit Spannung versorgt, wobei eine Unterspannungswarnung 14 vorgesehen ist. Die Avalanchestufe bzw. der Transistor 12 wird über einen Spannungs- bzw. Schaltwandler 16 betrieben, da dieser Bauteil mit höherer Spannung als Batteriespannung zu betreiben ist. Zur Einregelung der Impulsdauer der Sendesignale dient ein Ladungsspeicher 11, dessen Kapazität über fernsteuerbare Einstelleinrichtungen 18,19, z.B. Relais, umgeschaltet werden kann, und zur Einstellung des Linienabstandes des Kammspektrums dient die extern ansteuerbare Teilerschaltung 10. Zur Konstanthaltung der Amplitude des Kammspektrums kann eine Widerstandsbeschaltung des Transistors 12 in der Avalanchestufe vorgesehen werden; zur Konstanthaltung der Frequenz ist der Oszillator 9 als Quarzoszillator ausgebildet.

Der Betrieb des Kammgenerators erfolgt über den Opto-Decoder 8, der über Lichtwellenleiter 3 von einem Rechner ferngesteuert wird und die entsprechende Steuerfunktion übernimmt.

Im folgenden erfolgt eine Erklärung der Funktionsweise der Lawinenstufe anhand der Fig.6. Der Taktgenerator 9 liefert Triggerimpulse mit der gewünschten Wiederholrate. Die Erzeugung der gewünschten, sehr kurzen Impulse erfolgt durch den im kontrollierten Lawinendurchbruch betriebenen Transistor 12. Der Ladungsspeicher 11 in Form einer Speicherleitung, bestehend aus den Kondensatoren C20, C21, C22, ihrer Verbindungsleitung bis zum Kollektor des Transistors 12 sowie den Relaiskontakten aus Relais 18,19, wird über die Serienschaltung von R28 und L3 auf positives Potential aufgeladen (die Spannung wird dabei an den Transistortyp angepaßt), während der Transistor 12 noch gesperrt ist. Bei Eintreffen der Triggerflanke an der Basis des Transistors 12 bricht der Transistor aufgrund der hohen Kollektor-Emitter-Spannung durch. Es kann jedoch nur solange Strom fließen, als die Speicherleitung 11 Ladungsträger liefern kann. Ist die Speicherleitung entladen, so liegt der Kollektor auf Nullpotential und der Transistor 12 sperrt wieder. Dazu muß die Zeitkonstante des RL-Gliedes R28 - L3 so bemessen sein, daß zwar die Speicherleitung 11 während der Sperrphase vollständig aufgeladen werden kann, jedoch nach Entladung der Speicherleitung 11 durch den Durchbruch des Transistors 12 kein weiterer Stromfluß möglich ist, welcher den Durchbruch aufrecht erhalten würde. Um die Impulsdauer wählbar zu gestalten, ist die Speicherkapazität der Speicherleitung 11 über die Relaiskontakte und Kondensatoren C20/ C21/ C22/ veränderlich; je größer die Kapazität (Parallelschaltung!), desto länger ist die Impulsdauer.

Die Elemente R26 und L2 bilden zusammen mit C19 ein Differenzierglied und verkürzen den Trigger-Impuls.

Das Ausgangssignal wird in der vorliegenden Schaltung mit NPN-Transistoren am Arbeitswiderstand R27 (Emitterwiderstand) abgegriffen. Die Verwendung eines PNP-Transistors und Arbeitswiderstandes im Kollektorkreis ist ebenfalls möglich. Der Signalverlauf am Eingang und am Ausgang (U_{E}...Eingangsspannung, U_{A}... Ausgangsspannung) der Lawinenstufe ist in Fig.7 dargestellt, die den Signalverlauf am Eingang (oben) und am Ausgang (unten) der Lawinenstufe bzw. an der Basis und am Emitter des Transistors 12 zeigt. Die Zahlenwerte gelten für ein 1MHz-Spektrum.

Der Quarzoszillator 9 erzeugt z.B. eine 15MHz-Schwingung; die gegebenenfalls programmierbare Teiler schaltung 10 erzeugt daraus die Grundfrequenzen, insbesondere in Form einer Rechteckschwingung, die z.B. 10 kHz bei einer bei einer Teilung durch 1500 bzw. 1MHz bei einer Teilung durch 15 usw. betragen können. Mit diesen Grundfrequenzen wird der Transistor 12 angesteuert, der im Lawinendurchbruch arbeitet. Der Transistor schaltet bei Anliegen der Flanke des Impulses entsprechend Fig.7 durch, wobei das Wiederabschalten durch die Speicherleitung 11 bewirkt wird, welche die Kollektorspannung absenkt und den Durchbruchsbetrieb unterbricht. Am Ausgang des Transistors 12 entstehen sehr kurze Impulse mit einer typischen Impulsbreite von einer Nanosekunde für ein Kammspektrum, das bis über 1 GHz reicht. Die Impulse kehren periodisch wieder und ein derartiger "Puls" hat (bei Darstellung über der Zeitachse in der Fourierdarstellung (Darstellung des enthaltenen Frequenzspektrums) ein Kammspektrum.

Als mit dem Kammgenerator koppelbare Antennen sind symmetrische oder unsymmetrische lineare Antennen, elektrisch kurze Antennen (Dipole), Rahmenantennen, Aperturstrahler, Schlitzantennen oder Leitungen, insbesondere Zwei- oder Mehrdrahtleitungen, mit gegebenenfalls einstellbarem Abschlußwiderstand, vorgesehen. Diese angeführten Sendeantennen besitzen untereinander unterschiedliche Abstrahlcharakteristik.

Der dargestellte Kammgenerator liefert ein breitbandiges amplituden- und frequenzstabiles Impulsspektrum, das durch den Betrieb des Bipolartransistors im kontrollierten Lawinendurchbruch erzeugt wird. Diese Art der Impulserzeugung hat den Vorteil daß kein breitbandiger und damit teurer Impulsverstärker benötigt wird, da bereits am Ausgang des Kammgenerators eine ausreichend hohe Leistung verfügbar ist.

Der eingebaute Quarzoszillator garantiert das stabile Kammspektrum mit konstanten, durch umschaltbare Teilungsfaktoren beliebig wählbaren Abständen der einzelnen Spektrallinien.

Gemäß Fig.4 und 4a wird ein periodisches impulsförmiges Signal mit der Periodendauer t und der Pulsdauer τ (Fig.4a), zusammengesetzt aus einer Grundschwingung mit der Frequenz 1/t und einer unendlichen Anzahl von Schwingungen mit Frequenzen von ganzzahligen Vielfachen dieser Grundfrequenz. Die Einhüllende der Amplituden dieser Schwingungen besitzt in ihrer spektralen Darstellung die Form (sin x)/x (x=Aγ/t gemäß Fig.4b). Die Impulsdauer τ der Impulse des in der Erfindung eingesetzten Generators ist so kurz, daß im interessierenden Frequenzbereich die Amplituden der einzelnen Spektrallinien nahezu konstant sind (Kammspektrum). Ein signifikanter Abfall der Schwingungsamplituden erfolgt daher gemäß obiger Funktion erst bei nicht interessierenden Frequenzen. Mit der Impulswiederholrate 1/t kann der Frequenzabstand der einzelnen Spektrallinien auf den gewünschten Wert eingestellt werden.

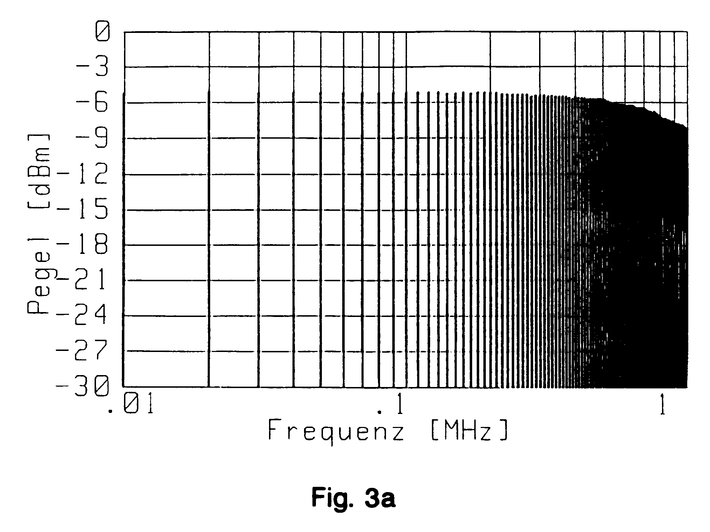

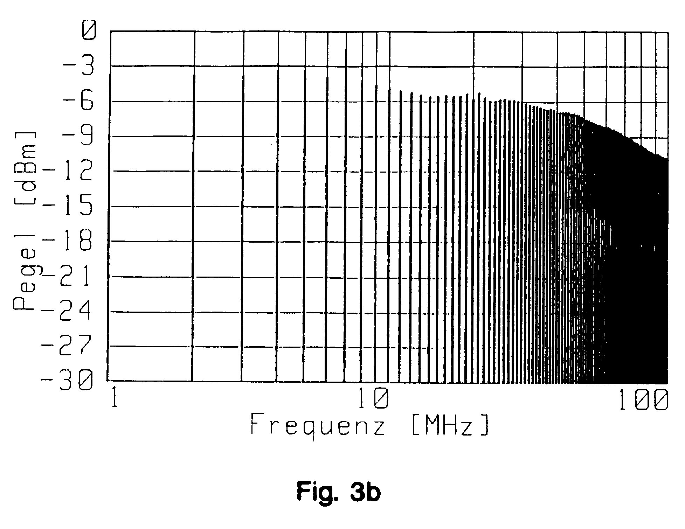

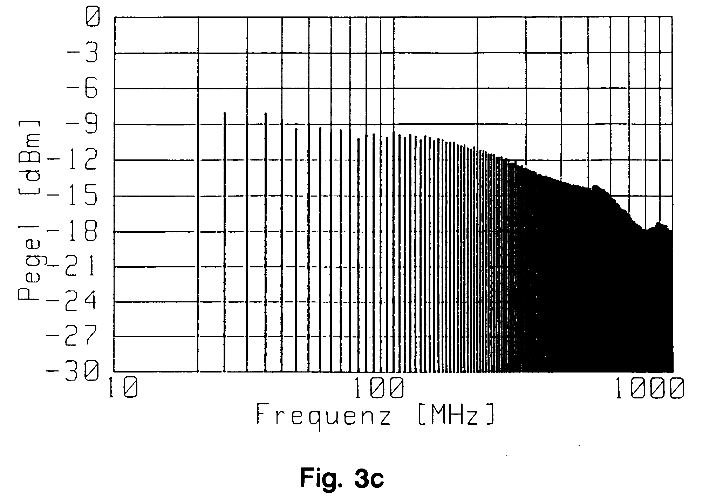

In der dargestellten Ausführungsform sind demzufolge Spektren mit 10kHz, 1 Mhz und 5 MHz Linienabstand wählbar. Gemäß Fig.3 sind für diese Spektren Frequenzbereich und Leistungspegel je Spektrallinie ersichtlich.

Durch den Batteriebetrieb des Meßsenders wird jede Beeinflussung der einzelnen Charakteristiken durch metallische Zuleitungen vermieden, wenn zudem die Fernsteuerung des Senders für die vollautomatische Meßwerterfassung und Meßwertverarbeitung über Lichtwellenleiter erfolgt. Über das Netzwerk 5 werden die angeschlossenen Antennen phasenrichtig und pegelrichtig angespeist, obwohl diese unterschiedliche Anschlußparameter bzw. Abstrahlcharakteristiken besitzen. Die zuvor angeführten Sendeantennen können die in realen Prüflingen auftretenden strahlenden Leiterelemente ersetzen, welche üblicherweise sind:
- Funksendeantennen: ersetzt durch unsymmetrische lineare Antennen und Rahmenantennen
- Gehäuseschlitze und -öffnungen: durch Rahmenantennen und Aperaturstrahler
- Kabelverbindungen nach außen: durch Zwei- und Mehrdrahtleitungen und symmetrische lineare Antennen
- Masseflächen im Gehäuseinneren: durch Aperturstrahler
- Leiterbahnen im Inneren des Prüflings: durch symmetrische Antennen, elektrisch kurze Dipole, Rahmenantennen und Zwei- und Mehrdrahtleitungen.

Erfindungsgemäß können somit Meßstrecken mit verschiedenen Feldern kalibriert werden bzw. Prüflinge durch Einsatz verschiedener Antennen nachgebildet werden.

Eine Kalibrierung einer Meßstrecke für Störfeldstärkemessungen, z.B. einer Absorberhalle, kann mit Hilfe eines erfindungsgemäßen Meßsenders bzw Funkstörsimulators folgendermaßen durchgeführt werden. Der Meßsender bzw Funkstörsimulator wird beispielsweise einmal mit einer linearen Antenne bestückt bzw. betrieben und einmal mit einer Rahmenantenne. Die Größe dieser Antennen wird dabei so gewählt, daß die Antennen in denjenigen Prüflingen, für die die Kalibrierung gelten soll, Platz finden würden. Der Meßsender wird sodann einmal in Verbindung mit der zu kalibrierenden Meßeinrichtung, z.B. Absorberhalle, und einmal in Verbindung mit einer Referenzeinrichtung, z.B. einem normgerechten Freifeldmeßgelände, betrieben. Die Feldstärken werden in beiden Fällen entsprechend einer gewissen Prüfnorm gemessen. Der Vergleich der Meßergebnisse der zu kalibrierenden Meßeinrichtung und der normgerechten Meßeinrichtung liefert die Kalibrierfaktoren für die zu kalibrierende Meßeinrichtung.

Für Störfeldstärkemessungen an Prüflingen, deren Strahlungscharakteristik a priori nicht bekannt ist, was normalerweise der Fall ist, wird folgendermaßen vorgegangen: Rechnerisch wird für jede Frequenz der Mittelwert der gemessenen Kalibrierfaktoren ermittelt. Dieser Mittelwert wird bei Störfeldstärkemessungen an realen Prüflingen als Kalibrierfaktor verwendet. Die Abweichungen der insbesondere für lineare Antennen und Rahmenantennen gültigen Kalibrierfaktoren vom Mittelwert ergibt die größtmögliche Unsicherheit des Meßergebnisses an.

Der Vorteil der Erfindung gegenüber herkömmlichen Kalibriereinrichtungen besteht darin, daß Meßstrecken für Störfeldstärkemessungen für genau die Erfordernisse der realen Meßpraxis kalibriert werden können und nicht nur für eine einzige spezielle Feldverteilung, die in der Meßpraxis praktisch nie auftritt. Mit einer derartigen Kalibrierung kann die Meßunsicherheit bei Störfeldstärkemessungen in Absorberhallen signifikant verringert werden.

Die Simulation der Störstrahlung von realen Prüflingen kann mit Hilfe des Meßsenders als Funkstörsimulator dadurch erfolgen, daß der Kammgenerator über das Netzwerk 5 mit mehreren Antennen 7 gleichzeitig verbunden wird; je nach elektrischen Aufbau des Prüflings werden die entsprechenden Antennenarten eingesetzt und angespeist.

Zur Simulierung eines Prüflings werden zumindest eine Rahmenantenne und eine lineare Antenne eingesetzt, da diese die am häufigsten vorkommenden Störstrahler sind bzw. die unterschiedlichsten Charakteristiken besitzen. Bei der Simulierung von Prüflingen werden die einzelnen Antennen gleichzeitig angespeist. Bei der Kalibrierung der Meßstrecken werden die einzelnen mit den Kammgenerator verbundenen Antennen hintereinander, d.h. zu verschiedenen Meßzyklen, angespeist oder die Antenne, deren abgestrahltes Feld vermessen wurde, wird abmontiert und eine Antenne mit unterschiedlicher Abstrahlcharakteristik wird an den Kammgenerator über das ihr zugeordnete (Kopplungs) Netzwerk angeschaltet.

Die Vermessung der Felder kann in verschiedener, vorzugsweise jedoch in der genormten Weise erfolgen. Je mehr Kalibrierfaktoren für unterschiedlich abstrahlende Antennen in einer Meßstrecke bekannt sind, desto genauer können Prüflinge bezüglich der von ihnen erzeugten Störfelder vermessen werden; bisher erfolgte jedoch nur eine Kalibrierung bezüglich eines einzigen Feldes, sodaß durch die erfindungsgemäße Vorgangsweise eine beträchtliche Verbesserung des Prüfstandards erreicht wird, insbesondere wenn die Kalibrierfaktoren über den gesamten Frequenzbereich bestimrrt werden. Darüber hinaus zeigte es sich, daß die Kalibrierfaktoren für unterschiedliche Abstrahlcharakteristiken bzw. unterschiedliche Wellen unterschiedliche Verläufe besitzen, sodaß keinesfalls Kalibrierfaktoren, die für eine Antenne bestimmter Abstrahlungscharakteristik ermittelt wurden, auch für die Vermessung von Abstrahlungen einer anderen Antenne eingesetzt werden können.

Die Antennengröße von Dipolantennen wird so gewählt, daß die höchste Feldstärke bei jenen Frequenzen erzeugt wird, bei denen im Freien die stärksten Funksignale vorhanden sind. Im Frequenzbereich 30 bis 1000 MHz ist dies im UKW-Bereich (ca. 88 bis 104 MHz) der Fall. Damit wird bei Referenzmessungen auf einem Freifeld-Meßgelände der Abstand zwischen Nutz- und Störsignalen maximiert. Vorteilhaft ist es somit, wenn lineare Antennen bzw. Dipole einer Länge von 110 - 150 cm, vorzugsweise 140 cm, insbesondere von etwa 130 cm, eingesetzt sind.

Für Rahmenantennen wählt man die Abmessungen des Rahmens derart, daß quadratische Rahmenantennen einer Größe von 25 bis 40 cm x 25 bis 40 cm, vorzugsweise etwa 30 x 30 cm, eingesetzt sind. Wählt man als Abmessung z.B. 10 Cm oder weniger, so ist die erzielte Feldstärke für praktische Messungen am Freifeld-Meßgelände unzureichend. Wählt man die Rahmenabmessungen sehr groß, z.B. 50 cm oder mehr, so tritt eine starke Welligkeit im Frequenzgang der erzeugten Feldstärke auf. Als guter Kompromiß hat sich ein Rahmendurchmesser bzw. eine Seitenlänge von ca. 30 cm erwiesen.

Zur Verringerung der Welligkeit des Frequenzganges bei Frequenzen oberhalb von ca 200 MHz empfiehlt sich eine Verkleinerung der Antennen und gegebenenfalls eine Anspeisung über ein Widerstandsnetzwerk. Diese Verkleinerung erfolgt in Abhängigkeit der gewünschten Sendeleistung und kann zweckmäßigerweise etwa bis zu einer Verkleinerung auf bis zu ca.30% der angegebenen Werte führen.

## Patentansprüche

1. Meßsender mit einem vorzugsweise batteriebetriebenen, ein frequenzstabiles Kammspektrum erzeugenden Kammgenerator und einer Antennenanordnung, dadurch gekennzeichnet, daß zur Erzeugung wählbarer Feldverteilungen die an den das Kammspektrum zudem amplitudenstabil erzeugenden Kammgenerator (2) angeschlossene Antennenanordnung zumindest zwei Antennen (7) unterschiedlicher Art umfaßt, welche Antennen (7), vorzugsweise zumindest eine Rahmenantenne und eine lineare Antenne, durch unterschiedliches Konstruktionsprinzip bedingt, voneinander unterschiedliche Abstrahlungscharakteristiken besitzen und zum Kalibrieren von Meßstrecken für Störfeldstärkemessungen einzeln hintereinander oder zum Einsatz des Meßsenders als Funkstörsimulator gleichzeitig vom Kammgenerator (2) über zumindest ein Kopplungsglied und gegebenenfalls zumindest ein Netzwerk (5) zur Anpassung der Antennen (7) an den Kammgenerator (2) angespeist sind.

2. Meßsender nach Anspruch 1, dadurch gekennzeichnet, daß die Antennen (7) unterschiedlicher Abstrahlungscharakteristik von symmetrischen oder unsymmetrischen linearen Antennen, elektrisch kurzen Antennen, Rahmenantennen, Aperturstrahlern, Schlitzantennen oder Leitungen, insbesondere Zwei- oder Mehrdrahtleitungen mit gegebenenfalls einstellbaren Abschlußwiderständen od.dgl., gebildet sind.

3. Meßsender mit einem ein frequenzstabiles Kammspektrum erzeugenden Kammgenerator, der von einem gegebenenfalls batteriegespeisten Oszillator getriggert ist, dadurch gekennzeichnet, daß zur Anspeisung der eine Mehrzahl von, durch ihre unterschiedlichen Konstruktionsprinzipien bedingt, unterschiedliche Abstrahlungscharakteristiken besitzenden Antennen (7) bestehende Antennenanordnung mit einem breitbandigen, insbesondere bis 1 GHz reichenden, amplituden- und frequenzstabilen Kammspektrum, insbesondere mit einer Sendeleistung von bis zu 0,07 mW, vorzugsweise bis zu 0,1 mW, pro Spektrallinie, dem Oszillator (9) ein im kontrollierten Lawinendurchbruch betriebener Transistor (12), vorzugsweise ein Bipolartransistor, nachgeschaltet ist, dessen beim Durchbruch gewonnenes Signal als Kammspektrum den Antennen (7) der Antennenanordnung zugeführt ist.

4. Meßsender nach Anspruch 3, dadurch gekennzeichnet, daß der Transistor (12) über einen Spannungswandler (16) von einer Batterie (15) angespeist ist.

5. Meßsender nach Anspruch 3 oder 4, dadurch gekennzeichnet, daß zur Einstellung des Linienabstandes des Kammspektrums eine extern ansteuerbare Teilerschaltung (10) vorgesehen ist, die dem Oszillator (9) nachgeschaltet ist.

6. Meßsender nach einem der Ansprüche 3 bis 5, dadurch gekennzeichnet, daß zur Konstanthaltung der Amplitude des Kammspektrums eine von Widerständen gebildete Transistorbeschaltung vorgesehen ist.

7. Meßsender nach einem der Ansprüche 3 bis 6, dadurch gekennzeichnet, daß zur Konstanthaltung der Frequenz ein Quarzoszillator (9) vorgesehen ist.

8. Meßsender nach einem der Ansprüche 3 bis 7, dadurch gekennzeichnet, daß die Antennen (7) unterschiedlicher Abstrahlungscharakteristik von besonders hohe und besonders niedrige Feldwellenwiderstände im Nahfeld der Antenne erzeugenden Antennen, vorzugsweise von einer Kombination von symmetrischen linearen Antennen, z.B. Drahtleitungen oder Dipolen, mit Rahmen- oder Schlitzantennen, gebildet sind.

9. Meßsender nach einem der Ansprüche 3 bis 8, dadurch gekennzeichnet, daß zur Betriebsregelung des Kammgenerators (2) eine Steuerschaltung vorgesehen ist.

10. Meßsender nach Anspruch 9, wenn dieser nach Anspruch 5 rückbezogen ist, dadurch gekennzeichnet, daß der Kammgenerator (2) als Steuerschaltung einen Opto-Decoder (8) umfaßt, an dessen Eingang ein Lichtwellenleiter (3) für eine insbesondere von einem Rechner erfolgende Fernsteuerung angeschlossen ist, wobei der Ausgang des Opto-Decoders (8) an die Teilerschaltung (10) und ein den Transistor (12) bzw. die Linienbreite steuerndes Zeitglied (11), z.B. einen Ladungsspeicher, angeschlossen ist.

11. Meßsender nach einem der Ansprüche 3 bis 10, dadurch gekennzeichnet, daß die Antennen (7) ohne Zwischenschaltung eines Filters und/oder Leistungsverstärkers an den Transistor (12) angeschlossen sind.

12. Meßsender nach einem der Ansprüche 3 bis 11, dadurch gekennzeichnet, daß lineare Antennen bzw. Dipole einer Länge von 120 bis 140 cm, vorzugsweise von etwa 130 cm, eingesetzt sind.

13. Meßsender nach einem der Ansprüche 3 bis 12, dadurch gekennzeichnet, daß quadratische Rahmenantennen einer Größe von 25 bis 40 cm x 25 bis 40 cm, vorzugsweise 30 x 30 cm, eingesetzt sind.

14. Meßsender nach einem der Ansprüche 3 bis 13, dadurch gekennzeichnet, daß der Oszillator (9), gegebenenfalls über eine Teilerschaltung (10) zur Einstellung der Wiederholungsrate der Impulse, an die Basis des Transistors (12) angeschlossen ist, wobei die Antennen emitter- oder kollektorseitig an den Transistor (12) angeschlossen sind.

15. Meßsender nach Anspruch 14, dadurch gekennzeichnet, daß dem Transistor (12) zur Steuerung der Impulsdauer bzw. Linienbreite kollektorseitig ein steuerbarer Ladungsspeicher (11) vorgeschaltet ist, mit dem die kollektorseitige Kapazität des Transistors (12) einstellbar ist.

16. Verfahren zum Kalibrieren von Meßstrecken für Störfeldstärkemessungen von elektrischen Geräten, wobei die Kalibrierfaktoren über das Frequenzspektrum, insbesondere bis 1 GHz, ermittelt werden, wobei in einer bekannten Referenzmeßstrecke, vorzugsweise einer Normmeßstrecke oder einem Freifeld-Meßgelände, und in einer zu kalibrierenden Meßstrecke mit ein und demselben einen Kammgenerator enthaltenden Meßsender oder mit ein und demselben Funkstörsender, insbesondere mit gleichen Betriebsparametern, Felder erzeugt und jeweils in gleicher Weise gemessen werden, insbesondere unter Verwendung eines Meßsenders nach einem der Ansprüche 1 bis 15, dadurch gekennzeichnet, daß die Felder in der zu kalibrierenden Meßstrecke und in der Referenzmeßstrecke mit zumindest zwei, durch unterschiedliches Konstruktionsprinzip bedingt, voneinander unterschiedliche Abstrahlcharakteristiken besitzenden Antennen, vorzugsweise mit zumindest einer Rahmenantenne und einer linearen Antenne, in aufeinanderfolgenden Sende-Meßzyklen erzeugt und, insbesondere unter Einhaltung der jeweils gleichen Betriebsparameter, die der eingesetzten Antennenart entsprechend ausgebildeten Felder vermessen werden und daß aus dem Vergleich der Meßwerte die Kalibrierfaktoren als Funktion der Frequenz für die Feldstärkeverteilungen jeder der abstrahlenden Antennen berechnet werden.

17. Verfahren nach Anspruch 16, dadurch gekennzeichnet, daß für jede Frequenz die Extremwerte der ermittelten, für die bestimmte Feldverteilung geltenden Kalibrierfaktoren der Feldstärkeverteilung ermittelt werden und ein Mittelwert, vorzugsweise das geometrische oder arithmetische Mittel, der Extremwerte berechnet wird.

18. Verfahren nach Anspruch 17, dadurch gekennzeichnet, daß der Abstand des berechneten Mittelwertes von den Extremwerten berechnet wird und als maximal möglicher Meßfehler definiert bzw. für die Auswertung herangezogen wird.

19. Verfahren nach einem der Ansprüche 16 bis 18, dadurch gekennzeichnet, daß als Antennen unterschiedlicher Abstrahlungscharakteristik symmetrische oder unsymmetrische lineare Antennen, elektrisch kurze Antennen, Rahmenantennen, Aperturstrahler, Schlitzantennen oder Leitungen, insbesondere Zwei- oder Mehrdrahtleitungen mit vorzugsweise einstellbaren Abschlußwiderständen od.dgl., vorzugsweise zumindest eine Kombination einer symmetrischen linearen Antenne, z.B. einem Dipol oder einer Drahtleitung, mit einer Rahmen- oder Schlitzantenne, eingesetzt werden.

## Claims

1. A measuring transmitter comprising a comb generator which is preferably battery operated and which generates a frequency-stable comb spectrum, and an antenna arrangement, characterized in that for generating selectable field distributions, the antenna arrangement that is connected to the comb generator (2) which generates an also amplitude-stable comb spectrum, has at least two antennas (7) of different types, which antennas (7), preferably at least one loop antenna and a linear antenna, due to different principles of construction, have emission characteristics which are different from each other and for calibration of measurement sections for measurement of interference field strenghts are individually powered in series or for use of the measuring transmitter as a radio interference simulator simultaneously by the comb generator (2) via at least one coupling member and optionally at least one network (5) for adapting the antennas (7) to the comb generator (2).

2. Measuring transmitter according to claim 1, characterized in that the antennas (7) of different emission characteristics are symmetrical or asymmetrical linear antennas, electrically limited antennas, loop antennas, radiating apertures, slot antennas or lines, in particular dual-wire or multiple-wire lines with optionally adjustable terminal resistances or the like.

3. Measuring transmitter comprising a comb generator generating a frequency-stable comb spectrum and being triggered by an optionally battery operated oscillator, characterized in that for powering the antenna arrangement comprising a plurality of antennas (7) having different emission characteristics because of their different construction principles, with a broad-amplitude-stable and frequency-stable comb spectrum that in particular extends up to 1 GHz, in particular with a transmitting output of up to 0.07 mW, preferably up to 0.1 mW, per spectrum line, a transistor (12) operated in a controlled cascade break-down, preferably a bipolar transistor, is connected downstream to the oscillator (9), the signal of which transistor obtained during break-down is provided to the antennas (7) of the antenna arrangement as the comb spectrum.

4. Measuring transmitter according to claim 3, characterized in that the transistor (12) is powered by a battery (15) via a voltage transformer (16).

5. Measuring transmitter according to claim 3 or 4, characterized in that for adjusting the line spacing of the comb spectrum, an externally controllable splitter circuit (10) is provided that is connected at a position downstream of the oscillator (9).

6. Measuring transmitter according to any of claims 3 to 5, characterized in that for keeping the amplitude of the comb spectrum constant, a transistor circuit is provided that is formed by resistors.

7. Measuring transmitter according to any of claims 3 to 6, characterized in that for keeping the frequency constant, a quartz oscillator (9) is provided.

8. Measuring transmitter according to any of claims 3 to 7, characterized in that the antennas (7) of different emission characteristics are formed by antennas which generate particularly high and particularly low field characteristic impedances in the proximity field of the antenna, preferably by a combination of symmetrical linear antennas, for example wire lines or dipoles, with loop antennas or slot antennas.

9. Measuring transmitter according to any of claims 3 to 8, characterized in that a control circuit is provided for operation control of the comb generator (2).

10. Measuring transmitter according to claim 9, if this is related back to claim 5, characterized in that the comb generator (2) comprises an optical decoder (8) as the control circuit, to the input of which an optical wave guide (3) is connected for a remote control, in particular by a computer, the output of the optical decoder (8) being connected to the splitter circuit (10) and to a timing member (11), for example a carriage storage, that controls the transistor (12) or the width of the lines.

11. Measuring transmitter according to any of claims 3 to 10, characterized in that the antennas (7) are connected to the transistor (12) without the interposition of a filter and/or of a power amplifier.

12. Measuring transmitter according to any of claims 3 to 11, characterized in that linear antennas or dipoles are used that have a length of 120 to 140 cm, preferably of about 130 cm.

13. Measuring transmitter according to any of claims 3 to 12, characterized in that square loop antennas are used having a size of 25 to 40 cm x 25 to 40 cm, preferably of 30 x 30 cm.

14. Measuring transmitter according to any of claims 3 to 13, characterized in that the oscillator (9) is connected to the base of the transistor (12), optionally via a splitter circuit (10) for setting the repetition rate of the pulses, the antennas being connected to the transistor (12) on the emitter side or on the collector side.

15. Measuring transmitter according to claim 14, characterized in that a controllable carrier storage (11) is connected upstream at the collector side to the transistor (12) for controlling the pulse length or the line width, by which carrier storage the capacitance on the collector side of the transistor (12) can be adjusted.

16. A process for calibrating measuring sections for interference field strength measurement of electrical devices, wherein the calibrating factors are detected by means of the frequency spectrum, in particular up to 1 GHz, comprising generating fields in a known reference measuring section, preferably a standard measuring section or an open field measuring area, and in a measuring section to be calibrated by means of one and the same measuring transmitter comprising a comb generator or by means of one and the same radio interference transmitter, in particular with the same operational parameters, and measuring said fields in always the same manner, in particular by using a measuring transmitter according to any of claims 1 to 15, characterized in that the fields are generated in the measuring section to be calibrated and in the reference measuring section by means of at least two antennas having emission characteristics which are different from each other because of the different construction principle, preferably by means of at least one loop antenna and a linear antenna, in sequential transmission-measurement cycles, and that the fields created in accordance with the types of antennas used are measured, in particular while maintaining the same respective operational parameters, and that the calibrating factors are calculated from a comparison of the measured values as a function of the frequency for the field strength distribution of each of the emitting antennas.

17. Process according to claim 16, characterized in that for each frequency, the extreme values of the calculated calibrating factors of the field strength distribution which are applicable to the defined field distribution, are detected and that a mean value of the extreme values is calculated, preferably the geometric or arithmetic means.

18. Process according to claim 17, characterized in that the difference between the calculated mean value and the extreme values is calculated and is used as the maximum possible measurement error or, respectively, for the calculation.

19. Process according to any of claims 16 to 18, characterized in that symmetrical or asymmetrical linear antennas, electrically short antennas, loop antennas, aperture emitters, slot antennas or conductors, in particular dual- or multi-wire conductors with preferably adjustable termination resistances or the like, preferably at least one combination of a symmetrical linear antenna, for example a dipole or a wire conductor, with a loop antenna or slot antenna, are used as antennas of different transmission charasteristic.

## Revendications

1. Emetteur de mesure avec un générateur de peigne. avantageusement alimenté par pile, produisant un spectre de peigne à fréquence stabie. et un système d'antennes. caractérisé en ce que, pour obtenir des distributions de champ pouvant être choisies, ledit système d'antennes relié au générateur de peigne (2) et produisant le spectre de peigne qui est en outre stabilisé en amplitude, comprend au moins deux antennes (7) de type différent, lesdites antennes (7), qui sont avantageusement au moins une antenne à cadre et une antenne linéraire. possédant du fait de leurs principes de construction différents des caractéristiques de rayonnement différentes, et étant alimentées par le générateur de peigne (2), moyennant au moins un élément de couplage et le cas échéant au moins un réseau (5) pour l'adaptation des antennes (7) au générateur de peigne (2), individuellement, l'une après l'autre, ou simultanément, lorsque l'émetteur de mesure est utilisé comme simulateur de parasites, en vue de l'étalonnage de sections de mesure servant à la détermination des intensités des champs parasitaires.

2. Emetteur de mesure selon la revendication 1, caractérisé en ce que les antennes (7) de caractéristiques de rayonnement différentes consistent en antennes linéaires symétriques ou asymétriques, antennes électriques courtes, antennes à cadre, excitateurs à trou, antennes à fentes ou conducteurs, en particulier bifilaires ou multifilaires, avec le cas échant des impédances de charge réglables, ou autres.

3. Emetteur de mesure avec un générateur de peigne générant un spectre de peigne à fréquence stable, déclenché par un oscillateur alimenté le cas échéant par pile, caractérisé en ce que pour l'alimentation du système d'antennes qui consiste en antennes (7) présentant un certain nombre de caractéristiques de rayonnement différentes dues à leurs principes de constructions différents, avec un spectre de peigne à large bande, en particulier allant jusqu'à 1 GHz, stabilisé en amplitude et en fréquence, en particulier avec une puissance d'émission pouvant aller jusqu'à 0,07 mW par raie spectrale, avantageusement jusqu'à 0,1 mW, un transistor (12) fonctionnant en claquage par avalanche contrôlé. avantageusement un transistor bipolaire, est placé en aval de l'oscillateur (9), le signal généré par claquage dudit transistor étant envoyé en tant que spectre de peigne aux antennes (7) du système d'antennes.

4. Emetteur de mesure selon la revendication 3, caractérisé en ce que le transistor (12) est alimenté par une pile (15) moyennant un transformateur de tension (16).

5. Emetteur de mesure selon la revendication 3 ou 4, caractérisé en ce qu'il est prévu en aval de l'oscillateur (9) un circuit diviseur (10) contrôlable de l'extérieur pour le régalge de l'écartement des raies du spectre de peigne.

6. Emetteur de mesure selon une des revendications 3 à 5, caractérisé en ce qu'il est prévu un montage à transistors constitué de résistances afin de maintenir constante l'amplitude du spectre de peigne.

7. Emetteur de mesure selon une des revendications 3 à 6, caractérisé en ce qu'il est prévu un oscillateur à quarz (9) afin de maintenir la fréquence constante.

8. Emetteur de mesure selon une des revendications 3 à 7, caractérisé en ce que les antennes (7) présentant des caractéristiques de rayonnement différentes consistent en antennes générant des impédances d'onde particulièrement élevées et particulièrement basses dans le champ proche desdites antennes, avantageusement en une combinaison d'antennes linéaires symétriques, p.ex. des conducteurs ou des dipôles, avec des antennes à cadre ou à fentes.

9. Emetteur de mesure selon une des revendications 3 à 8, caractérisé en ce qu'il est prévu un circuit pilote pour le réglage de régime du générateur de peigne (2).

10. Emetteur de mesure selon la revendication 9 lorsque celle-ci est basée sur la revendication 5, caractérisé en ce que le générateur de peigne (2) comporte comme circuit pilote un optodécodeur (8) à l'entrée duquel est connecté un guide d'ondes optiques (3) pour la commande à distance assurée en particulier par un ordinateur, la sortie de l'optodécodeur (8) étant connectée au circuit diviseur (10) et à un élément retardateur (11) contrôlant le transistor (12) et la largeur des raies, qui peut être p.ex. un accumulateur de charge.

11. Emetteur de mesure selon une des revendications 3 à 10. caractérisé en ce que les antennes (7) sont raccordées au transistor (12) sans que soient intercalés un filtre et/ou un amplificateur de puissance.

12. Emetteur de mesure selon une des revendications 3 à 11, caractérisé en ce que l'on utilise des antennes linéraires ou des dipôles d'une longueur de 120 à 140 cm, avantageusement 130 cm environ.

13. Emetteur de mesure selon une des revendications 3 à 12, caractérisé en ce que l'on utilise des antennes à cadre carrées d'une dimension comprise entre 25 et 40 cm x 25 à 40 cm, avantageusement 30 x 30 cm.

14. Emetteur de mesure selon une des revendications 3 à 13, caractérisé en ce que, pour le réglage du taux de répétition des impulsions, l'oscillateur (9) est connecté à la base du transistor (12) le cas échéant moyennant un circuit diviseur (10), les antennes étant connectées au transistor (12) côté émetteur ou côté collecteur.

15. Emetteur de mesure selon la revendication 14, caractérisé en ce que, pour la commande de la durée des impulsions et de la largeur des raies, le transistor (12) est précédé côté collecteur d'un accumulateur de charge (11) pilotable permettant de régler la capacité du transistor (12) côté collecteur.

16. Procédé d'étalonnage de sections de mesure servant à la détermination des intensités des champs parasitaires d'appareillages électriques, les facteurs d'étalonnage étant déterminés à partir du spectre de fréquence, en particulier jusqu'à 1 GHz, selon lequel des champs sont créés sur une section de mesure de référence connue, avantageusement une section de mesure étalon ou un terrain pour mesurages à champ libre, et sur une section de mesure à étalonner, et mesurés chaque fois de la même façon, au moyen d'un même émetteur de mesure contenant un générateur de peigne ou d'un même émetteur de signaux parasites, avantageusement avec les mêmes paramètres de fonctionnement, en particulier en utilisant un émetteur de mesure selon une des revendications 1 à 15, caractérisé en ce que, sur la section de mesure à étalonner et sur la section de mesure de référence, les champs sont créés selon des cycles successifs d'émission et de mesure par au moins deux antennes possédant des caractéristiques de rayonnement différentes du fait de leurs principes de construction différents et qui sont avantageusement au moins une antenne à cadre et une antenne linéaire, et que, en particulier en respectant pour chacun les mêmes paramètres de fonctionnement, les champs configurés en fonction du type d'antenne utilisé sont mesurés et que les facteurs d'étalonnage sont calculés à partir de la comparaison des valeurs mesurées, en tant que fonction de la fréquence, pour les répartitions d'intensité de champ de chacune des antennes émetteuses.

17. Procédé selon la revendication 16, caractérisé en ce que les valeurs extrêmes des facteurs d'étalonnage de la répartition de l'intensité de champ valables pour la répartition de champ donnée sont établies pour chaque fréquence et que l'on calcule la moyenne, avantageusement la moyenne géométrique ou arithmétique, des valeurs extrêmes.

18. Procédé selon la revendication 17, caractérisé en ce que l'on calcule l'écart entre la valeur moyenne calculée et les valeurs extrêmes et que cet écart est défini comme erreur de mesure maximale possible et/ou qu'il est utilisé pour l'évaluation.

19. Procédé selon une des revendications 16 à 18, caractérisé en ce que l'on utilise comme antennes présentant des caractéristiques de rayonnement différentes, des antennes linéaires symétriques ou asymétriques, des antennes électriques courtes. des antennes à cadre, des excitateurs à trou, des antennes à fentes ou des conducteurs, en particulier bifilaires ou multifilaires, avec le cas échant des impédances de charge réglables, ou autres, avantageusement au moins une combinaison d'une antenne linéaire symétrique, p.ex. un dipôle ou un conducteur, avec une antenne à cadre ou à fentes.
